(19) Europäisches Patentamt
European Patent Office
Office européen des brevets

(11) Publication number : 0 531 259 A1

# (12) EUROPEAN PATENT APPLICATION

(21) Application number : 92810659.0

(51) Int. Cl.$^5$ : C08G 73/10, G03F 7/038

(22) Date of filing : 27.08.92

(30) Priority : 05.09.91 US 755277

(43) Date of publication of application : 10.03.93 Bulletin 93/10

(84) Designated Contracting States : AT BE CH DE FR GB IT LI NL

(71) Applicant : CIBA-GEIGY AG
Klybeckstrasse 141
CH-4002 Basel (CH)

(72) Inventor : Jurek, Michael Joseph
103 Carrollwood Drive
Tarrytown, NY 10591 (US)

## (54) Photoimageable polyimide.

(57) The present invention relates to maleic anhydride terminated homopolyimides and copolyimides of aromatic tetracarboxylic acids and aromatic diamines which are substituted in the two ortho-positions relative to at least one N atom by alkyl, alkoxy, alkoxyalkyl, cycloalkyl or aralkyl and which contain about 0.0001 to about 25 mol% maleic anhydride, exhibit increased mechanical properties, such as, improvements in elongation at break and improved solvent resistance. The polyimides are suitable for the production of films, protective coatings and photographic relief images.

EP 0 531 259 A1

Jouve, 18, rue Saint-Denis, 75001 PARIS

The present invention relates to maleic anhydride terminated homopolyimides and copolyimides of aromatic tetracarboxylic acids and diamines, at least 5 mol% of the diamines being aromatic diamines which are substituted in the two ortho-positions relative to at least one N atom by alkyl, cycloalkyl, alkoxy, alkoxyalkyl or aralkyl and which contain about 0.0001 to about 25 mol% maleic anhydride and their use for the production of protective films or photographic relief images, if at least 5 mol % of benzophenonetetracarboxylic acid radicals are present in the polyimide, based on the tetracarboxylic acids present. The polyimides of the present invention are particularly well suited for use in microelectronic coating applications.

Polyimides are plastics with useful thermomechanical properties. U.S. Patent No. 4,629,777 discloses homopolyimides and copolyimides of aromatic tetracarboxylic acids and diamines, at least 5 mol% of the diamines being aromatic diamines which are substituted in the two ortho-positions relative to at least one N atom by alkyl, cycloalkyl, alkoxy, alkoxyalkyl or aralkyl useful in electronic and semiconductor applications.

It has now been found that soluble polyimides which exhibit increased mechanical properties, such as, improvements in elongation at break and improved solvent resistance are obtained with the maleic anhydride terminated polyimides of the present invention.

Accordingly, it is an object of the present invention to provide polyimides with increased mechanical properties, such as, improvements in elongation at break and improved solvent resistance.

Various other objects and advantages of this invention will become apparent from the following description thereof.

The invention relates to a maleic anhydride terminated homopolyimide or copolyimide of at least one aromatic tetracarboxylic acid and at least one aromatic diamine, which essentially consist of 5 to 99.999 mol % of at least one structural element of formula I

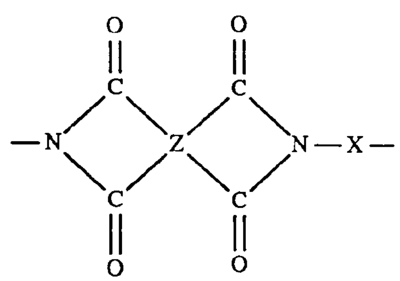

(I)

and 95-0 mol % of at least one structural element of the formula II

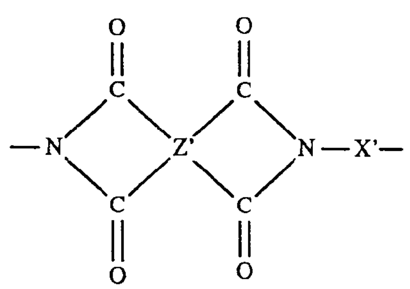

(II)

wherein Z is an unsubstituted or substituted tetravalent aromatic radical to which in each case two carbonyl groups are bonded in the ortho- or peri-position, X is the divalent radical of an aromatic diamine, Z′ has the same meaning as Z, or is a different tetravalent organic radical to Z, and X′ is the divalent radical of an organic diamine which differs from X, wherein the aromatic radical of X is substituted in the two ortho-positions relative to at least one N atom by alkyl, cycloalkyl, alkoxy, alkoxyalkyl or aralkyl, or wherein two adjacent C atoms of the aromatic radical are substituted by alkylene and wherein said homopolyimide or copolyimide contains about 0.0001 to about 25 mol % maleic anhydride groups and has a weight average molecular weight of at least 10,000.

Surprisingly, the inclusion of the maleic anhydride terminal group does not interfere with the unsaturated sites which would quench the photosensitivity of the polyimide. The maleic anhydride is preferably present in the homopolyimide or copolyimide in an amount of from about 0.0001 to about 0.1 mol % and most preferably about 0.0001 to about 0.0005 mol %.

The maleic anhydride terminated homopolyimides and copolyimides preferably contain the structural elements of the formula I in an amount of 20-99.999 mol %, in particular 50-99.999 mol % and especially 80-99.999

mol %, and structural elements of the formula II in an amount of 80 to 0 mol %, in particular 50 to 0 mol % and especially 20 to 0 mol %.

An aromatic radical X is preferably a divalent, mononuclear or dinuclear phenylene radical. A linear or branched alkyl or alkoxy substituent of X can contain 1 to 20, preferably 1 to 6 and in particular 1 to 4, C atoms, a linear or branched alkoxyalkyl substituent of X can contain 2 to 12, in particular 2 to 6, C atoms, an alkylene substituent of X can contain 3 or 4 C atoms, a cycloalkyl substituent of X can contain 5 to 8, in particular 5 or 6, ring carbon atoms and an aralkyl substituent of X can contain 7 to 12 C atoms. Alkoxyalkyl is preferably alkoxymethyl and aralkyl is preferably benzyl.

Examples of substituents are: methyl, ethyl, propyl, isopropyl, n-butyl, isobutyl, tert.-butyl, pentyl, hexyl, octyl, dodecyl, tetradecyl, eicosyl, cyclopentyl, cyclohexyl, methylcyclohexyl, methoxy, ethoxy, propoxy, butoxy, pentoxy, hexoxy, methoxymethyl, methoxyethyl, ethoxymethyl, propoxymethyl, butoxymethyl, benzyl, methylbenzyl and phenethyl. Preferred radicals are methoxymethyl, ethoxymethyl, methyl, ethyl, isopropyl, trimethylene and tetramethylene. Particularly preferred radicals are isopropyl, ethyl and, especially, methyl.

A substituted aromatic radical X can contain 8 to 30, in particular 8 to 25, C atoms. The aromatic radical is preferably a pyridine radical or, in particular, a hydrocarbon radical which is substituted by alkyl, alkoxyalkyl, alkoxy, trimethylene or tetramethylene. The aromatic radical can contain other substituents, for example halide, such as F, Cl or Br. In a preferred sub-group, mononuclear aromatic radicals are phenylene radicals and dinuclear aromatic radicals are naphthylene or bisphenylene radicals.

A preferred sub-group of maleic anhydride terminated polyimides according to the invention are those in which an aromatic radical X has the formula III, IIIa and/or IIIb

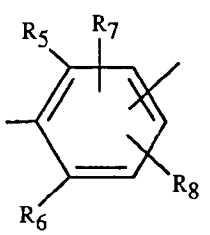

(III)

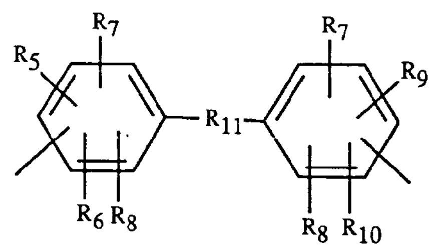

(IIIa)

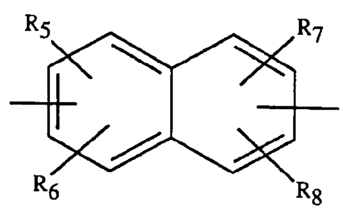

(IIIb)

in which, in formula III, the free bonds are in the meta- or para-position relative to one another, in formula IIIa the free bonds are preferably in the meta- or para-position relative to the $R_{11}$ group and $R_5$ and $R_5$ are bonded in the two ortho-positions of the free bond, and in formula IIIb the free bonds are in the 2-, 3-, 6- or 7-positions and $R_5$ and $R_5$ are in the two ortho-positions of the free bonds, $R_{11}$ is a direct bond, -O-, -S-, -SS-, -SO-, $-SO_2-$, -CO-, -COO-, -NH-,

-N-alkyl,

with 1 to 6 C atom in the alkyl,

-N-phenyl , -N-benzyl , ·

-CONH-, -CON-alkyl- with 1 to 6 C atoms in the alkyl, -CON-phenyl-, -CON-benzyl-,

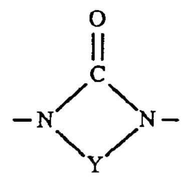

in which Y is

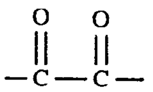 , 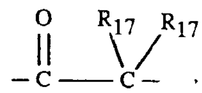 , or 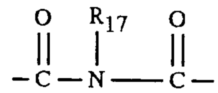

and $R_{17}$ is a hydrogen atom, $C_1$-$C_6$-alkyl or phenyl, linear or branched alkylene with 1 to 3 C atoms, alkylidene which has 2 to 12 C atoms and is unsubstituted or substituted by Cl or F, cycloalkylidene with 5 or 6 ring carbon atoms, phenylene, phenylenedioxy or the group $R_3SiR_4$,

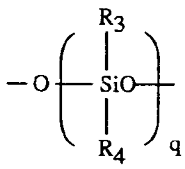 or 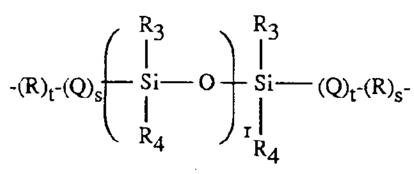

in which $R_3$ and $R_4$ are alkyl or alkoxy with 1 to 6 C atoms, phenyl, benzyl, phenoxy or benzyloxy, r is a number from 1 to 20, t is 0 or 1, s is 0 or 1, R is -O- or -S-, Q is $C_1$-$C_6$-alkylene and q is a number from 1 to 100, $R_5$ and $R_5$ are alkyl, or alkoxy with 1 to 12 C atoms, alkoxyalkyl with 2 to 12 C atoms, cyclopentyl, cyclohexyl or benzyl, or, in the formula III or IIIa, $R_5$ and $R_7$ are bonded in adjacent positions and together are trimethylene or tetramethylene, in which case $R_6$ can also be a hydrogen atom, or $R_7$ and $R_8$ are hydrogen atoms or independently have the meanings of $R_5$ and $R_6$, and $R_9$ and $R_{10}$ are hydrogen atoms or independently have the meanings of $R_5$ and $R_5$, or $R_7$ and $R_9$ in formula IIIa together are trimethylene or tetramethylene. $R_5$ and $R_5$ are preferably alkyl with 1 to 6 C atoms, in particular methyl, ethyl, n-propyl or isopropyl. The free bonds of the formula IIIa are preferably in the meta-position or, in particular, para-position relative to the $R_{11}$ group. The alkyl in the $R_{11}$ radicals can be, for example, methyl, ethyl, propyl, isopropyl, n-butyl or pentyl. An alkylene radical $R_{11}$ is preferably ethylene or, in particular, methylene. An alkylidene radical $R_{11}$ preferably contains 2 to 6 C atoms. Examples are ethylidene, 2,2-butylidene, 2,2- or 3,3-pentylidene, hexafluoropropylidene and, in particular, 2,2-propylidene. A cycloalkylidene radical $R_{11}$ can be, for example, cyclopentylidene or, in particular, cyclohexylidene. The $R_{11}$ group is preferably a direct bond, -O-, -S-, $-SO_2-$, -CO-, alkylene or alkylidene. $R_{11}$ is particularly preferably a direct bond, -O- or, in particylar, -CO- or $-CH_2-$. $R_3$ and $R_4$ are preferably alkyl, in particular methyl or phenyl. R is preferably -O-, Q is preferably methylene or ethylene, q is preferably a number from 1 to 10 and r is a number from 1 to 20, in particular 1 to 10.

Another group of aromatic radicals X are those of the formula

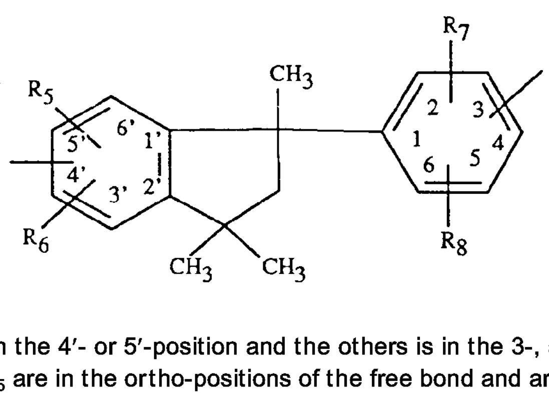

in which one free bond is in the 4′- or 5′-position and the others is in the 3-, 5- or, preferably 4-position and $R_5$ and $R_6$ and/or $R_7$ and $R_5$ are in the ortho-positions of the free bond and are alkyl or alkoxy with 1 to 12 C atoms or alkoxyalkyl with 2 to 12 C atoms.

A particularly preferred sub-group of maleic anhydride terminated polyimides according to the invention

are those in which X in formula I is a radical of the formula

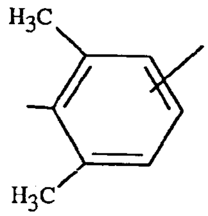
,
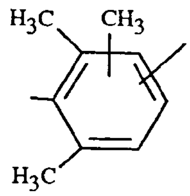
,
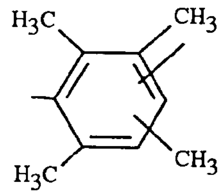
or
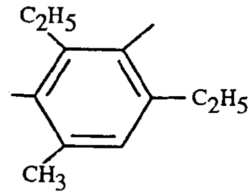

in which the free bonds are in the meta- or para-position relative to one another, or of the formula

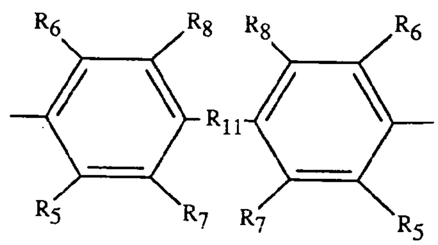

in which $R_5$ and $R_6$ independently of one another are methyl, ethyl, n-propyl or isopropyl, $R_7$ and $R_8$ are hydrogen atoms or have the meaning of $R_5$, or $R_5$ and $R_7$ together are trimethylene or tetramethylene and $R_5$ and $R_5$ are hydrogen atoms, and $R_{11}$ is a direct bond, $CH_2$, 2,2-propylidene or CO. Of these dinuclear radicals, those in which $R_5$, $R_5$, $R_7$ and $R_8$ are methyl are particularly preferred. Copolyimides which contain at least 2 different radicals of these formula are a further preferred embodiment of the invention.

Maleic anhydride terminated copolyimides according to the invention contain at least two different structural elements, the number of different structural elements essentially depending on the desired properties and the field of use. They preferably contain 2 to 4 different structural elements, in which case the structural elements may differ only in the radical X in the formula I. In a particularly preferred embodiment of such maleic anhydride terminated copolyimides, the polymers contain structural elements of ortho-disubstituted phenylenes, in particular of 1,3-phenylenes.

Examples of X are: 2,6-dimethyl-1,4- or -1,3-phenylene, 2,6-diethyl-1,4- or -1,3-phenylene, 2,6-dimethyl-5-chloro-1,4-, or -1,3-phenylene, 2-methyl-6-ethyl-1,4- or -1,3-phenylene, 2-methyl-6-isopropyl-1,4- or -1,3-phenylene, 2,6-diisopropyl-1,4- or -1,3-phenylene, 2,6-dimethoxy-1,4- or -1,3-phenylene, 2,6-diethoxy-1,4- or -1,3-phenylene, 2-methyl-6-methoxy-1,4- or -1,3-phenylene, 2,6-dibenzyl- 1,4- or -1,3-phenylene, 2,6-dimethoxymethyl-1,4- or -1,3-phenylene, 2,5,6-trimethyl-1,4- or - 1,3-phenylene, 2,5,6-triethyl-1,4- or -1,3-phenylene, 2,4,6-trimethyl-1,3-phenylene, 2,3,5,6-tetramethyl-1,4-phenylene, 2,4,5,6-tetramethyl-1,3-phenylene, tetrahydro-1,4- or -1,3-naphthylene and radicals of the formula

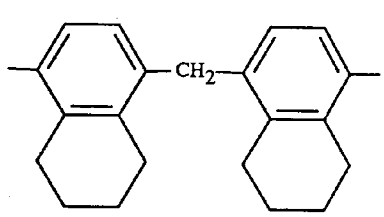
,
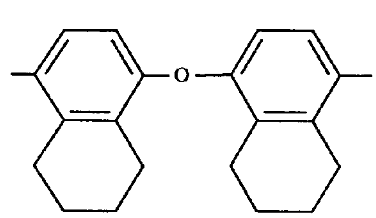
,

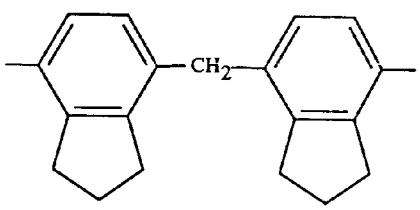,
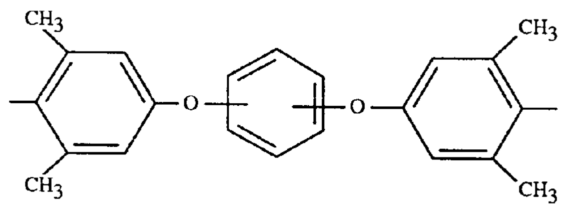,

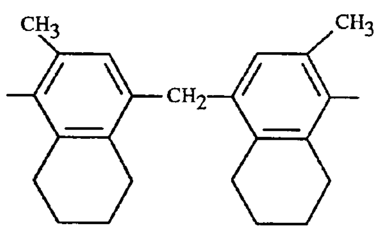,
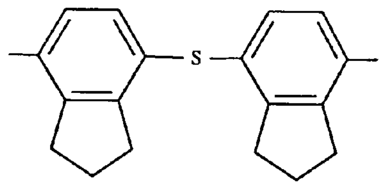,

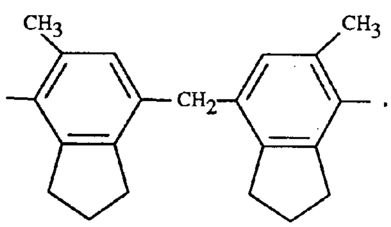,
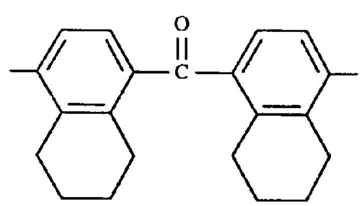,

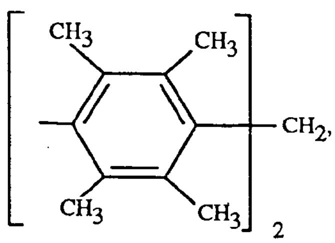
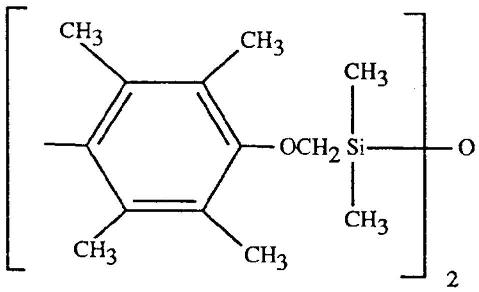,

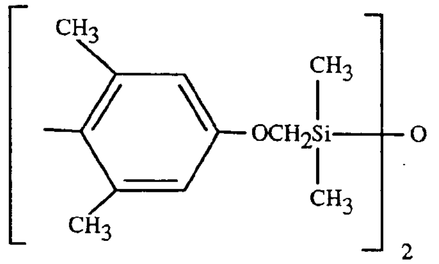,

as well as

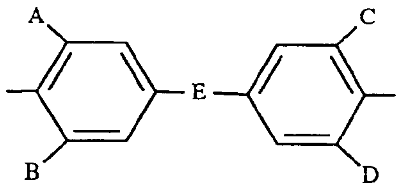

,

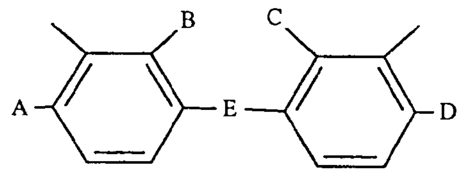

and

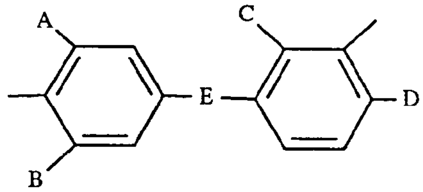

in which A, B, C, D and E have the meanings given in the table which follows. The free positions in the phenyl nuclei can be occupied by one or two other substituents G or H in each nucleus, it being possible for G or H to have the meaning given in the following table:

| E | A | B | C | D |
|---|---|---|---|---|
| $CH_2$ | Methyl | Methyl | H | H |
| $CH_2$ | Methyl | Ethyl | H | H |
| $CH_2$ | Ethyl | Ethyl | H | H |
| $CH_2$ | Isopropyl | Isopropyl | H | H |
| $CH_2$ | Methoxymethyl | | H | H |
| $CH_2$ | Benzyl | Benzyl | H | H |

| | | | | |
|---|---|---|---|---|
| $CH_2$ | Methyl | Methyl | Methyl | H |
| $CH_2$ | Ethyl | Ethyl | Ethyl | H |
| $CH_2$ | Isopropyl | Isopropyl | Methyl | Methyl |
| $CH_2$ | Methoxymethyl | | Methyl | H |
| $CH_2$ | Methyl | Ethyl | Methyl | H |
| $CH_2$ | Methoxymethyl | | Methoxymethyl | |
| $CH_2$ | Methyl | Methyl | Methyl | Methyl |
| $CH_2$ | Ethyl | Ethyl | Ethyl | Ethyl |
| $CH_2$ | Methyl | Methyl | Ethyl | Ethyl |
| $CH_2$ | Ethyl | Ethyl | Isopropyl | Isopropyl |
| $CH_2$ | Isopropyl | Isopropyl | Isopropyl | Isopropyl |
| $CH_2$ | Isopropyl | Isopropyl | Methyl | H |
| $CH_2$ | Methoxy | Methoxy | Methyl | Methyl |
| O | Methyl | Methyl | H | H |
| O | Ethyl | Ethyl | H | H |
| O | Methyl | Methyl | Methyl | H |
| O | Methyl | Methyl | Methyl | Methyl |
| O | Methyl | Methyl | Ethyl | Ethyl |
| S | Methyl | Methyl | H | H |
| S | Ethyl | Ethyl | H | H |
| S | Methyl | Methyl | H | H |
| S | Methyl | Methyl | Methyl | Methyl |
| S | Ethyl | Ethyl | Ethyl | Ethyl |
| S | Methyl | Methyl | Ethyl | Ethyl |
| CO | Methyl | Methyl | Methyl | H |
| CO | Methyl | Methyl | H | H |
| CO | Methyl | Methyl | Methyl | Methyl |
| $SO_2$ | Methyl | Methyl | Ethyl | H |
| $SO_2$ | Methyl | Methyl | H | H |
| $SO_2$ | Methyl | Methyl | Methyl | Methyl |
| $SO_2$ | Ethyl | Ethyl | Methyl | Methyl |
| SO | Methyl | Methyl | Methyl | Methyl |
| SO | Methyl | Methyl | H | H |
| COO | Methyl | Methyl | H | H |
| COO | Methyl | Methyl | Methyl | Methyl |
| $CONCH_3$ | Methyl | Methyl | H | H |

| | | | | |
|---|---|---|---|---|
| $NCH_3$ | Methyl | Methyl | Ethyl | Ethyl |
| $NCH_3$ | Methyl | Methyl | Methyl | Methyl |
| CONH | Methyl | Methyl | - | - |
| NH | Ethyl | Methyl | Ethyl | Methyl |
| NH | Methyl | Methyl | Methyl | Methyl |
| $Si(Methyl)_2$ | Methyl | Methyl | H | H |
| $Si(Phenyl)_2$ | Methyl | Methyl | Methyl | Methyl |
| $Si(OMethyl)_2$ | Ethyl | Ethyl | H | H |
| $Si(OPhenyl)_2$ | Methyl | Methyl | Methyl | Methyl |
| $-OSi(Methyl)_2O-$ | Methyl | Methyl | Methyl | Methyl |
| Ethylene | Methyl | Methyl | H | H |
| Ethylene | Methyl | Methyl | Methyl | Methyl |
| Ethylene | Ethyl | Ethyl | H | H |
| Ethylene | Methyl | Methyl | Ethyl | Ethyl |
| Phenylene | Methyl | Methyl | Methyl | Methyl |
| Phenylene | Ethyl | Ethyl | H | H |
| 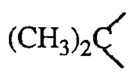 | Methyl | Ethyl | Methyl | Ethyl |
| 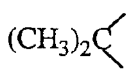 | Methyl | Methyl | Methyl | Methyl |
| 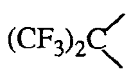 | Methyl | Methyl | Methyl | Methyl |
| direct bond | Methyl | Methyl | H | H |
| direct bond | Methyl | Ethyl | Methyl | Ethyl |
| direct bond | Methyl | Ethyl | Methyl | H |
| direct bond | Ethyl | Ethyl | Ethyl | Ethyl |
| direct bond | Methoxy | Methoxy | Methoxy | Methoxy |
| direct bond | Isopropyl | Isopropyl | H | H |
| direct bond | Methoxy-methyl | Methoxy-methyl | Methoxy-methyl | Methoxy-methyl |

The diamines from which X is derived are known or can be prepared by known processes. Si-containing diamines are described in U.S. Patent Specification 3,435,002 and European Patent A-0,054,426. Diamines with the

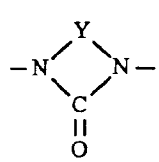

group can be prepared from the diisocyanates described in German Offenlegungsschrift 2,318,170. Diamines substituted by alkyl or cycloalkyl, in particular ethyl or propyl, are accessible by alkylation of unsubstituted or

partly substituted aromatic diamines with alkenes or cycloalkenes (cf. U.S. Patent Specification 3,275,690). Polynuclear, in particular dinuclear, aromatic diamines are obtainable via condensation of corresponding monoamines with aldehydes or ketones.

X′ in the structural element of the formula II can be linear or branched alkylene with 7 to 30 C atoms, cycloalkylene with 5 to 8 ring carbon atoms, aralkylene with 7 to 30 C atoms, arylene with 6 to 22 C atoms and/or a polysiloxane radical.

A divalent aliphatic radical X′ in formula I preferably contains 6 to 30, in particular 6 to 20, C atoms. In a preferred sub-group, X′ is linear or branched alkylene, which can be interrupted by oxygen atoms, NH, $NR_a$, $^{\oplus}N(R_a)_2G^{\ominus}$, cyclohexylene, naphthylene, phenylene or hydantoin radicals. $R_a$ can be, for example, alkyl with 1 to 12 C atoms, cycloalkyl with 5 to 6 ring C atoms, phenyl or benzyl. $G^{\ominus}$ is an anion of a protic acid, for example halide, sulfate or phosphate. In a preferred embodiment, R and/or R′ are linear or branched alkylene with 6 to 30 C atoms, $-(CH_2)_m-R_{13}-(CH_2)_n-$ in which $R_{13}$ is phenylene, naphthylene, cyclopentylene or cyclohexylene and m and n independently of one another are the number 1, 2 or 3, $-R_{14}-(OR_{15})-O-R_{14}-$, in which $R_{14}$ is ethylene, 1,2-propylene, 1,3-propylene or 2-methyl-1,3-propylene, $R_{15}$ is ethylene, 1,2-propylene, 1,2-butylene, 1,3-propylene or 1,4-butylene and p is a number from 1 to 100, or

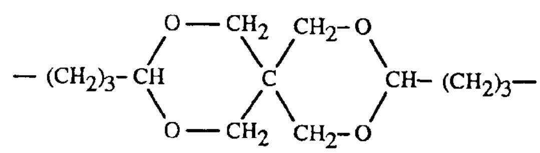

Examples of aliphatic radicals are: methylene, ethylene, 1,2- or 1,3-propylene, 2,2-dimethyl-1,3-propylene, 1,2-, 1,3- or 1,4-butylene, 1,3- or 1,5-pentylene, the hexylenes, heptylenes, octylenes, decylenes, dodecylenes, tetradecylenes, hexadecylenes, octadecylenes and eicosylenes, 2,4,4-trimethylhexylene, 1,10-dialkyldecylene, in which the alkyl preferably has 1 to 6 C atoms, substituted 1,11-undecylenes, for example those described in European Patent B-0,011,559, radicals of Jeffamines, for example

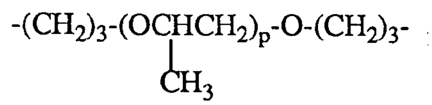

in which p is 1 to 100 or $-(CH_2)_3-(O(CH_2)_4)_p-O-(CH_2)_3-$, in which p is 1-100, dimethylenecyclohexane, xylylene and diethylenebenzene.

The aliphatic radical interrupted by heterocyclic radicals can be, for example, those which are derived from N,N′-aminoalkylated hydantoins or benzimidazoles. Examples are N,N′-(γ-aminopropyl)-5,5-dimethyl-hydantoin or -benzimidazolone and those of the formula

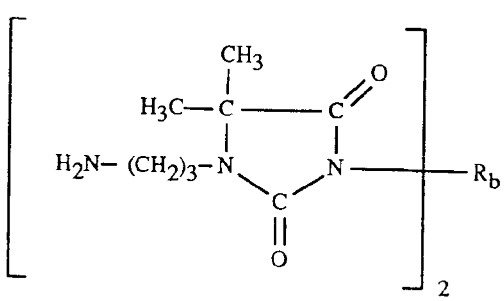

in which $R_b$ is alkylene with 1 to 12, preferably 1 to 4, C atoms or

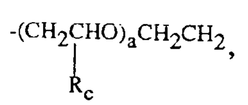

in which $R_c$ is a hydrogen atom or methyl and a is an integer from 1 to 20.

Examples of suitable substituents for the aliphatic radicals are hydroxy, halide, such as F or Cl, or alkoxy with 1 to 6 C atoms.

A divalent cycloaliphatic radical X′ in formula I preferably contains 5 to 8 ring C atoms and is, in particular, mononuclear or dinuclear cycloalkylene which has 5 to 7 ring C atoms and is unsubstituted or substituted by alkyl, which preferably contains 1 to 4 C atoms. In a preferred embodiment, a cycloaliphatic radical X′ is a radical of the formula

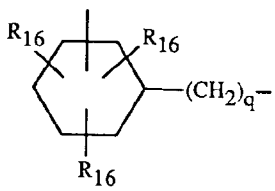
or
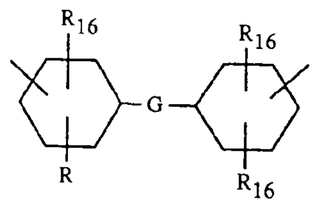

in which q is 0 or 1, the radicals $R_{16}$ independently are hydrogen or alkyl with 1 to 6 C atoms and G is a direct bond, O, S, $SO_2$, alkylene with 1 to 3 C atoms or alkylidene with 2 to 6 C atoms. $R_{16}$ is preferably ethyl or methyl, G is preferably methylene and the alkylidene preferably contains 2 or 3 C atoms, and is, for example, ethylidene or 1,1- or 2,2-propylidene.

Examples of a cycloalkylene radical X′ are: 1,2- or 1,3-cyclopentylene, 1,2-, 1,3- or 1,4-cyclohexylene, cycloheptylene, methylcyclopentylene, methyl- or dimethyl-cyclohexylene, 3- or 4-methylenecyclohex-1-yl, 5-methyl-3-methylenecyclohex-1-yl, 3,3′- or 4,4′-biscyclohexylene, 3,3′-dimethyl-4,4′-biscyclohexylene and 4,4′-bis-cyclohexylene ether, sulfone, -methane or -2,2-propane, and the radicals of bis-aminomethyltricyclodecane, bis-aminomethylnorbornane and methanediamine.

A cycloaliphatic radical X′ is particularly preferably 1,4- or 1,3-cyclohexylene, 2,2,6-trimethyl-6-methylenecyclohex-4-yl, methylenebis(cyclohex-4-yl) or methylenebis-(3-methylcyclohex-4-yl).

An araliphatic radical X′ preferably contains 7 to 30 C atoms. The aromatic groups are preferably substituted in the same manner as an aromatic radical X′, including the preferred substitutions, but are at least monosubstituted, preferably in the ortho-position relative to the N atom. The araliphatic radical contains, in particular, 8 to 26 C atoms. The aromatic radical in the araliphatic radical is preferably a phenyl radical. An araliphatic radical X′ is, in particular, aralkylene which is unsubstituted or substituted on the aryl by alkyl, the alkylene radical being linear or branched. In a preferred embodiment, the araliphatic radical corresponds to the formula

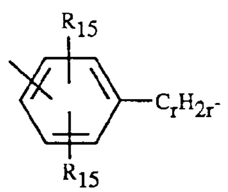

in which the radicals $R_{15}$ independently of one another are hydrogen atoms or, in particular, alkyl with 1-6 C atoms and r is an integer from 1 to 20.

The free bond is preferably in the m-position or p-position relative to the $C_rH_{2r}$ group and one or both of the radicals $R_{15}$ are preferably bonded in the o-position relative to the free bond.

Examples of an araliphatic radical X′ are: m- or p-benzylene, 3-methyl-p-benzylene, 3-ethyl-p-benzylene, 3,5-dimethyl-p-benzylene, 3,5-diethyl-p-benzylene, 3-methyl-5-ethyl-p-benzylene, p-phenylenepropylene, 3-methyl-p-phenylenepropylene, p-phenylenebutylene, 3-ethyl-p-phenylenepentylene and, in particular, longer-chain phenylenealkylene radicals, which are described, for example, in European Patent A-0,069,062: 6-(p-phenylene)-6-methylhept-2-yl, 6-(3′-methyl-p-phenylene)-6-methylhept-2-yl, 6-(3′-ethyl-p-phenylene)-6-methylhept-2-yl, 6-(3′,5′-dimethyl-p-phenylene)-6-methylhept-2-yl, 11-(p-phenylene)-2,11-dimethyl-dodec-1-yl and 13-(p-phenylene)-2,12-dimethyltetradec-3-yl.

An arylene radical X′ preferably contains 6 to 22 C atoms. The arylene is, in particular, a mononuclear or dinuclear phenylene radical. The arylene can be substituted, for example by alkyl or alkoxy with 1 to 6 C atoms, alkoxymethyl with 2 to 6 C atoms and/or halogen, such as F or Cl. Substituted aromatic radicals are preferred, since such copolyimides are in general more soluble. 1,3-Phenylenes which are substituted in one ortho-position relative to the free bond by alkyl with 1 to 4 C atoms, in particular methyl, are furthermore preferred.

In one embodiment, X′ has the formula IV

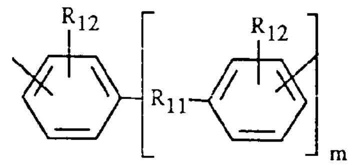

(IV)

in which m is 0 or 1, the free bonds are in the meta-position or, preferably, the ortho-position relative to the $R_{12}$ group, $R_{11}$ is as defined in formula IIIa and $R_{12}$ has the same meaning as $R_5$.

A preferred sub-group are arylene radicals of the formula IVa, IVb or IVc

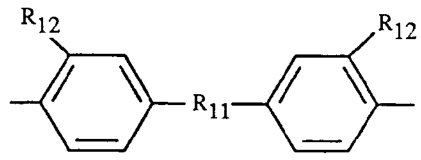

(IVa),

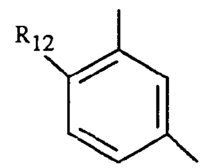

(IVb),

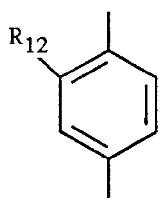

(IVc),

in which $R_{11}$ is a direct bond, -O-, -CO- or $-CH_2-$ and $R_{12}$ is methyl, ethyl, isopropyl, methoxy, ethoxy or a hydrogen atom.

Examples of diamines $H_2N-X'-NH_2$ with an aromatic radical are: 4,4′-methylenebis-(o-chloroaniline), 3,3′-dichlorobenzidine, 3,3′-sulfonyldianiline, 4,4′-diaminobenzophenone, 1,5-diaminonaphthalene, bis-(4-aminophenyl)-dimethylsilane, bis-(4-aminophenyl)-diethylsilane, bis-(4-aminophenyl)-diphenylsilane, bis-(4-aminophenyloxy)-dimethylsilane, bis-(4-aminophenyl)-ethylphosphine oxide, n-[bis-(4-aminophenyl)]-N-methylamine, N-[bis-(4-aminophenyl)]-N-phenylamine, 4,4′-methylenebis-(3-methylaniline), 4,4′-methylenebis-(2-ethylaniline), 4,4′-methylene-bis-(2-methoxyaniline), 5,5′-methylenebis-(2-aminophenol), 4,4′-methylenebis-(2-methylaniline), 4,4′-oxybis-(2-methoxyaniline), 4,4′-oxybis-(2-chloroaniline), 5,5′-oxybis-(2-aminophenol), 4,4′-thiobis-(2-methylaniline), 4,4′-thiobis-(2-methoxyaniline),4,4′-thiobis-(2-chloroaniline), 4,4′-sulfonylbis-(2-methylaniline), 4,4′-sulfonylbis-(2-ethoxyaniline), 4,4′-sulfonyl-bis-(2-chloroaniline), 5,5′-sulfonylbis-(2-aminophenol), 3,3′-dimethyl-4,4′-diaminobenzophenone, 3,3′-dimethoxy-4,4′-diaminobenzophenone, 3,3′-dichloro-4,4′-diaminobenzophenone, 4,4′-diaminobiphenyl, m-phenylenediamine, p-phenylenediamine, 4,4′-methylenedianiline, 4,4′-oxydianiline, 4,4′-thiodianiline, 4,4′-sulfonyldianiline, 4,4′-isopropylidenedianiline, 3,3′-dimethylbenzidine, 3,3′-dimethoxybenzidine, 3,3′-dicarboxybenzidine, diaminotoluene, 4,4′-methylenebis(3-carboxyaniline) and esters thereof, and 5-amino-1-(4-aminophenyl)-1,3,3-trimethylindane.

X′ can also be a divalent radical containing siloxane groups. This can have the formula

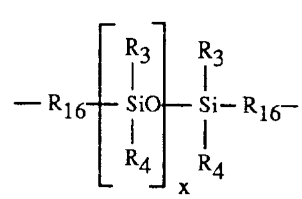

in which X is a rational number of at least 1, $R_3$ and $R_4$ are as defined and $R_{16}$ is a divalent hydrocarbon radical, for example alkylene with 1 to 12, preferably 1 to 6, C atoms, cycloalkylene with preferably 5 or 6 ring carbon atoms or phenylene. $R_3$ and $R_4$ are preferably methyl or phenyl and X is preferably a number from 1 to 1,000, in particular 1 to 100 and especially 1-10. Examples of alkylene are ethylene, 1,3- or 1,2-propylene and 1,3- or 1,4-butylene. Diamines containing this group X′ are described in U.S. Patent No. 4,030,948. Other suitable

diamines with a group X′ containing siloxane groups are described in U.S. Patent No. 3,435,002 and European Patent A-0,054,426.

It is known that some aliphatic and aromatic diamines, for example phenylenediamine or di(aminophenyl)methane, can favor the insolubility of polyimides. Such diamines are therefore preferably used in relatively small amounts. In this case, in particular, the polyimides contain at least 50 mol %, in particular 80 mol % and especially 90 mol %, of structural elements of the formula I.

A divalent aromatic radical Z or Z′ preferably contains 6 to 30, in particular 6 to 20, C atoms. In a preferred sub-group, Z and Z′ have the formula

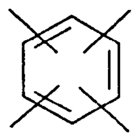 , 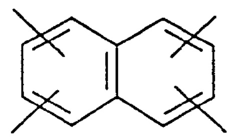 ,

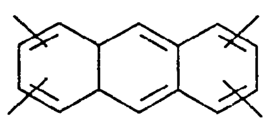 , 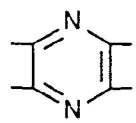 , 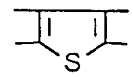 ,

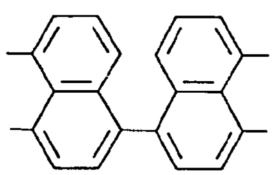 , 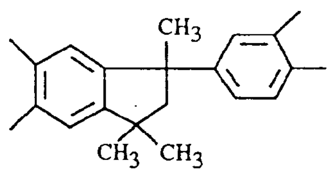 ,

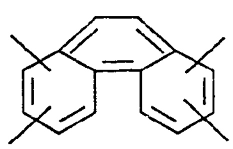 or 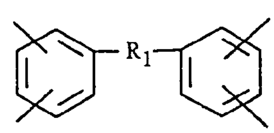

in which $R_1$ is a direct bond or a bridge group of the formula

-O-, -CO-, -S-, $-SO_2-$, 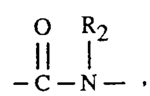 , 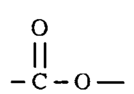 , 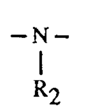 , 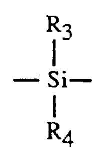 ,

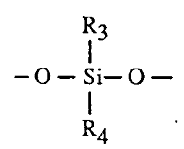 ,

-NH-, 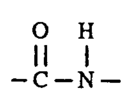 , $-CH_2-$, $-CH_2-CH_2-$, 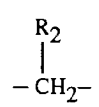 , 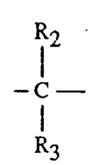 ,

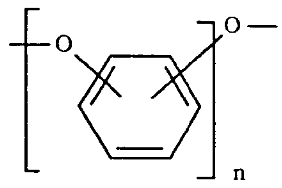

or

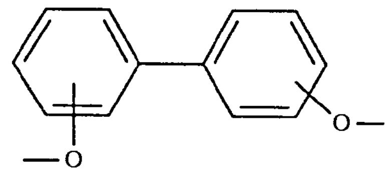

in which $R_2$, $R_3$ and $R_4$ are alkyl with 1 to 6 C atoms, phenyl or benzyl, and $R_3$ and $R_4$ are alkoxy with 1 to 6 C atoms, phenoxy or benzyloxy.

In the above formula, in each case two of the free bonds are always in the peri- and/or ortho-position.

A preferred sub-group for Z and Z′ are radicals of the formula

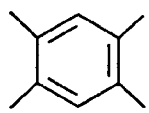

and/or

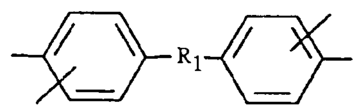

in which $R_1$ is a direct bond, -O-, $-SO_2-$, $-CH_2-$ or, in particular, -CO-.

Radicals of the formula

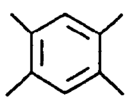

and/or

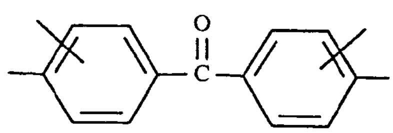

or mixtures thereof, for example those with at least 5 mol % of tetravalent benzophenone radicals, are very particularly preferred. The free bonds in the benzophenone radical are in the otho-position.

Examples of tetracarboxylic acid anhydrides with a radical of Z or Z′ are:

2,3,9,10-perylenetetracarboxylic acid dianhydride, 1,4,5,8-naphthalenetetracarboxylic acid dianhydride, 2,6-dichloronaphthalene-1,4,5,8-tetracarboxylic acid dianhydride, 2,7-dichloronaphthalene-1,4,5,8-tetracarboxylic acid dianhydride, 2,3,6,7-tetrachloronaphthalene-1,4,5,8-tetracarboxylic acid dianhydride, phenanthrene-1,8,9,10-tetracarboxylic acid dianhydride, pyromellitic dianhydride, 3,3′,4,4′-biphenyltetracarboxylic acid dianhydride, 2,2′,3,3′-biphenyltetracarboxylic acid dianhydride, 4,4′-isopropylidene-diphthalic anhydride, 3,3′-isopropylidenediphthalic anhydride, 4,4′-oxydiphthalic anhydride, 4,4′-sulfonyldiphthalic anhydride, 3,3′-oxydiphthalic anhydride, 4,4′-methylenephthalic anhydride, 4,4′-thiodiphthalic anhydride, 4,4′-ethylidenediphthalic anhydride, 2,3,6,7-naphthalenetetracarboxylic acid dianhydride, 1,2,4,5-naphthalenetetracarboxylic acid dianhydride, 1,2,5,6-naphthalenetetracarboxylic acid dianhydride, benzene-1,2,3,4-tetracarboxylic acid dianhydride, thiophene-2,3,4,5-tetracarboxylic acid dianhydride, 1-(3′,4′-dicarboxyphenyl)-1,3,3-trimethylindane-5,6-dicarboxylic acid dianhydride, 1-(3′,4′-dicarboxyphenyl)-1,3,3-trimethylindane-6,7-dicarboxylic acid dianhydride, 1-(3′,4′-dicarboxyphenyl)-3-methylindane-5,6-dicarboxylic acid dianhydride, 1-(3′,4′-dicarboxyphenyl)-3-methylindane-6,7-dicarboxylic acid dianhydride, 3,3′,4,4′-benzophenonetetracarboxylic acid anhydride and 4,5,3′,4′-benzophenonetetracarboxylic acid anhydride.

The maleic anhydride terminated polyimides according to the invention have average molecular weights (weight-average Mw) of at least 10,000, preferably at least 15,000. The upper limit essentially depends on properties which determine the processability, for example the solubility of the maleic anhydride terminated polyimides. It can be up to 50,000, preferably up to 75,000 and in particular up to 100,000. The polymers can furthermore be random polyimides or block polyimides. They are prepared by customary processes in equipment envisaged for this purpose.

The maleic anhydride terminated homopolyimide or copolyimide with structural elements of the formula I and/or II according to the present invention are prepared by subjecting maleic anhydride and at least one tetracarboxylic acid of the formula V

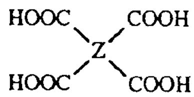

(V)

by itself or together with at least one tetracarboxylic acid of the formula Va, or polyimide-forming derivatives thereof;

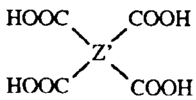

(Va)

to a polycondensation reaction with at least 5 mol %, based on the diamines, of at least one diamine of the formula VI

$H_2N\text{-}X\text{-}NH_2$ (VI)

by itself or together with at most 95 mol % of at least one diamine of the formula VIa

$H_2N\text{-}X'\text{-}NH_2$ (VIa)

and then cyclising the product, in a manner which is known per se. Instead of the tetracarboxylic acids, it is also possible to use polyimide-forming derivatives thereof, for example their esters, amides, halides, in particular the chlorides, and anhydrides.

The starting compounds are known and are commercially available or can be prepared by known processes. The reaction is advantageously carried out in solution; suitable inert solvents are mentioned below. The reaction temperatures can be -20 to 300°C.

Specifically, a procedure is advantageously followed in which the maleic anhydride, the tetracarboxylic acid dianhydride and the diamine are first reacted to form a maleic anhydride terminated polyamide acid intermediate and this polyamide acid is then cyclised, water being detached. The cyclisation can take place under the influence of heat. The cyclisation is advantageously carried out under the action of dehydrating agents, for example carboxylic acid anhydrides, such as acetic anhydride. The maleic anhydride terminated polyimides can then be isolated by customary processes, for example by removal of the solvent or precipitation by addition of a non-solvent.

The maleic anhydride terminated polyimides according to the invention are soluble in various solvents, if necessary with warming, and they exhibit improved mechanical properties over the unmodified polyimides, such as improvements in elongation at break, swelling, Young's modulus and tensile strength. They are outstandingly suitable for the production of films and protective coatings, in which case coating agents of a solution of the polyimide in a solvent can be used. The present invention furthermore relates to such a coating agent and to the use of the maleic anhydride terminated polyimides according to the invention for the production of protective coatings and films.

To produce the coated material according to the invention, the polymer or mixtures thereof are advantageously dissolved in a suitable organic solvent, if necessary with warming. Examples of suitable solvents are polar, aprotic solvents, which can be used by themselves or in mixtures of at least two solvents. Examples are: ethers, such as dibutyl ether, tetrahydrofuran, dioxane, methylene glycol, dimethylethylene glycol, dimethyldiethylene glycol, diethyldiethylene glycol, dimethyldiethylene glycol, dimethyltriethylene glycol, halogenated hydrocarbons, such as methylene chloride, chloroform, 1,2-dichloroethane, 1,1,1-trichloroethane and 1,1,2,2-tetrachloroethane, carboxylic acid esters and lactones, such as ethyl acetate, methyl propionate, ethyl benzoate, 2-methoxyethyl acetate, γ-butyrolactone, o-valerolactone and pivalolactone, carboxylic acid amides and lactams, such as formamide, acetamide, N-methylformamide, N,N-dimethylformamide, N,N-diethylformamide, N,N-dimethylacetamide, N,N-diethylacetamide, γ-butyrolactam, ε-caprolactam, N-methylpyrrolidone, N-acetylpyrrolidone, N-methylcaprolactam, tetramethylurea and hexamethylphosphoric acid amide, sulfoxides, such as dimethylsulfoxide, sulfones, such as dimethyl sulfone, diethyl sulfone, trimethylene sulfone and tetramethylene sulfone, trimethylamine, triethylamine, N-methylpyrrolidine, N-methylpiperidine, N-methylmorpholine and substituted benzenes, such as chlorobenzene, nitrobenzene, phenols or cresols.

Undissolved constituents can be removed by filtration, preferably pressure filtration. The concentration of polymer in the coating agent thus obtained is preferably not more than 50% by weight, in particular not more than 30% by weight and especially not more than 20% by weight, based on the solution.

Other customary additives which do not have an adverse influence on the photosensitivity can be incorporated during preparation of the solutions. Examples of these additives are delustering agents, flow control agents, fine-particled fillers, flameproofing agents, fluorescent brighteners, antioxidants, light stabilisers, stabilisers, dyes, pigments, adhesion promoters and antihalo dyes, for example those described in U.S. Patent No. 4,349,619.

The coating agent can be applied to suitable substrates or carrier materials by customary methods, such as dipping, brushing and spraying processes or whirler coating, cascade coating and curtain coating. Examples of suitable substrates are plastics, metals and metal alloys, semimetals, semiconductors, glass, ceramics and other inorganic materials, for example $SiO_2$ and $Si_3N_4$. The solvent is then removed, if necessary by warming and if necessary in vacuo. Non-tacky, dry, uniform films are obtained. The films applied can have coating thicknesses of up to about 500 μm or more, preferably of 0.5 to 500 μm and in particular 1 to 50 μm, depending on the use.

It has been found that the maleic anhydride terminated polyimides according to the invention are autophotocrosslinkable and can be crosslinked under the action of radiation if they contain at least 5 mol % of structural elements of the formula I in which Z is a radical of a benzophenonetetracarboxylic acid. Since the photosensitivity increases as the content of such structural elements increases, a content of at least 50 mol %, preferably at least 80 mol % and in particular at least 90 mol %, is advantageous.

Protective films of such maleic anhydride terminated polyimides can be further modified by the action of radiation, which means, for example, that increased heat stabilities are possible. There is also the possibility of using such maleic anhydride terminated polyimides as a photographic recording material for relief images. As a result of the direct crosslinking under the action of radiation, additives such as sensitisers can be avoided and the protective coatings and images have excellent electrical properties. The protective coatings and images are furthermore distinguished by their high heat stability and by no or only slight shrinkage during exposure to heat, which is of considerable advantage during their use, because virtually no distortion of imaged structures is observed.

The invention furthermore relates to coating agents containing such a radiation-sensitive maleic anhydride terminated polyimide in solution, a carrier material coated with such polyimides and the use of this material for the production of protective coating and photographic relief images. The coating thickness for this use is preferably 0.5 to 100 μm, in particular 1 to 50 μm and especially 1-10 μm.

The photostructuring or photocrosslinking can be brought about by high-energy radiation, for example by light, in particular in the UV range, by X-rays, laser light, electron beams and the like. The material according to the invention is outstandingly suitable for the production of protective films and passivating lacquers and as a photographic recording material for heat-stable relief images.

Examples of fields of use are protective, insulating and passivating lacquers in electrotechnology and electronics, photomasks for electronics, textile printing and the graphics industry, etch resists for the production of printed circuits and printing plates and integrated circuits, relays for the production of X-ray masks, solder-stopping lacquers, dielectrics for multi-layer circuits and structural elements for liquid crystal displays.

Protective films are produced by direct exposure, the exposure times essentially depending on the coating thicknesses and the photosensitivity.

The relief structure is produced photographically by imagewise exposure through a photomask and subsequent development with a solvent or a solvent mixture, the non-exposed portions being removed, after which, if appropriate, the image produced can be stabilised by after-treatment with heat.

The invention furthermore relates to a process of this type for the application of relief structures. Examples of suitable developers are the above mentioned solvents.

The polymer coating on the material according to the invention has a photosensitivity which is sufficient for many intended uses, and in some cases is high, and it can be photocrosslinked directly. The protective films and relief images are distinguished by good adhesion and high stability, mechanical strength and stability to chemicals. Only slight shrinkage is observed during after-treatment with heat. Furthermore, additives to achieve or increase photosensitivity can be avoided. The material is stable on storage, but is advantageously to be protected from the influence of light.

The examples which follow illustrate the invention in more detail.

## Example 1

This example illustrates the preparation of a typical maleic anhydride terminated polyimide in accordance with the present invention.

6.3232 g (0.0385 mole) of durene diamine and 8.8965 g (0.0315 mole) of ethylmethyldiaminodiphenylmethane are dissolved in 220 ml of N-methylpyrrolidinone in a 500 ml round bottom flask under nitrogen. 22.4423 g (0.700 mole) of benzophenonetetracarboxylic acid dianhydride and 0.0694 g ($7.08 \times 10^{-4}$ mole) of maleic anhydride are added to the flask at 5°C with stirring under nitrogen. The reaction mixture becomes deep red in color and stirred overnight under nitrogen. 21.4 ml of triethylamine is added and becomes homogeneous after

about 3 minutes. 59.4 ml of acetic anhydride is then added and the reaction mixture becomes slightly darker - deep reddish in color. The reaction mixture is then stirred for 24 hours. The reaction mixture is precipitated into water, washed with about 16 liters of water and put in a vacuum oven at 140°C to dry overnight.

The mechanical properties of the maleic anhydride terminated polyimide are tested using an Instron Analyzer. A 6.35 cm gap between jaws, a 0.9 kg full deflector load and 5.08 cm/minute crosshead speed on the aluminum mounted sample is used.

Thin film samples for Instron testing are prepared as follows:

A solution of 14 g polyimide in 100 ml of a suitable solvent (gamma-butyrolactone, N-methylpyrrolidinone, N,N′-dimethylacetamide) is filtered through 0.8 μm filters and 3-4 ml is dispensed onto a silicon wafer via syringe. The wafers are spun at 2000 rpm and the resultant film is soft-baked at 110°C on a hot plate for 3 minutes followed by 30 minutes in an air circulating oven at 110°C. A final baking is done at either 350°C for 0.5 hour or 400°C for 6 hours.

Sample films are diced to 3.2 mm wide strips and lifted off the silicon wafer by floating in a buffered hydrofluoric acid bath. The polymer strips are water washed, air dried and cut into 7.6 cm long strips for mounting in the aluminum holders.

Immediately after mounting the sample in the clips, the aluminum foil is cut. Each sample is inspected for area where the break appears to ensure epoxy failure is not measured. The results of the measurements for the maleic anhydride-terminated polyimide and an unmodified control (PROBIMIDE® 400 from CIBA-GEIGY Corporation) are provided in Tables 1-6.

TABLE 1

| SAMPLE 1 - MALEIC ANHYDRIDE TERMINATED POLYIMIDE - 0.5 HOUR AT 350°C | | | |
|---|---|---|---|
| | MODULUS (Y, GPa) | YIELD ELONGATION(%) | BREAKWAFER ELONGATION(%) |
| 1 | 2.89 | 7.50 | -- |
| 2 | 2.76 | 8.38 | -- |
| 3 | 2.94 | 8.25 | 87.4 |
| 4 | 2.77 | 9.00 | 90.4 |
| 5 | 2.68 | 9.50 | -- |
| 6 | 2.87 | 9.13 | 77.9 |
| 7 | 2.90 | 8.50 | 81.8 |
| 8 | 2.78 | 8.88 | 98.9 |
| 9 | 2.85 | -- | -- |
| 10 | 2.51 | 9.50 | 96.0 |
| 11 | 2.65 | 9.00 | 69.5 |
| 12 | 2.75 | 8.75 | 60.0 |
| 13 | 3.06 | 8.88 | -- |

TABLE 2

| SAMPLE 2 - MALEIC ANHYDRIDE TERMINATED POLYMIDE - 0.5 HOUR AT 350°C | | | |
|---|---|---|---|
| | MODULUS (Y, GPa) | YIELD ELONGATION(%) | BREAKWAFER ELONGATION(%) |
| 1 | 3.16 | 6.50 | 88.8 |
| 2 | 3.04 | 8.38 | 81.1 |
| 3 | 2.93 | 8.25 | -- |
| 4 | 3.66 | 8.75 | 93.8 |
| 5 | 3.22 | 9.25 | 84.4 |
| 6 | 2.59 | 9.50 | -- |
| 7 | 2.51 | 9.25 | 60.5 |
| 8 | 2.54 | 9.63 | -- |
| 9 | 2.82 | 9.50 | 57.9 |
| 10 | 2.58 | 9.38 | -- |
| 11 | 2.53 | 9.13 | 85.9 |
| 12 | 2.66 | 9.75 | 107 |
| 13 | 2.88 | 8.50 | 98.9 |
| 14 | 2.64 | 9.30 | 62.1 |

TABLE 3

| CONTROL#1 - PROBIMIDE® 400 - 0.5 HOUR AT 350°C | | | |
|---|---|---|---|
| | MODULUS (Y, GPA) | YIELD ELONGATION(%) | BREAKWAFER ELONGATION(%) |
| 1 | 2.65 | 8.50 | 100.0 |
| 2 | 2.53 | 8.95 | 70.3 |
| 3 | 2.96 | 8.13 | 75.3 |
| 4 | 2.68 | 7.88 | 109.8 |
| 5 | 2.29 | 9.50 | 79.7 |
| 6 | 2.60 | 8.63 | 98.5 |
| 7 | 2.54 | 9.13 | 90.0 |
| 8 | 2.66 | 8.63 | 85.3 |
| 9 | 2.76 | 9.00 | 63.6 |
| 10 | 2.56 | 8.40 | 94.7 |
| 11 | 2.54 | 8.63 | 91.8 |
| 12 | 2.51 | 9.13 | 106.4 |

TABLE 4

| CONTROL#2 - PROBIMIDE® 400 - 0.5 HOUR AT 350°C | | | |
|---|---|---|---|
| | MODULUS (Y, GPa) | YIELD ELONGATION(%) | BREAKWAFER ELONGATION(%) |
| 1 | 2.70 | 8.00 | 80.8 |
| 2 | 2.98 | 7.25 | 90.0 |
| 3 | 2.79 | 8.70 | 98.8 |
| 4 | 2.71 | 8.25 | 79.3 |
| 5 | 3.03 | 8.44 | 100.9 |
| 6 | 2.92 | 7.81 | 82.8 |
| 7 | 2.82 | 8.44 | 73.4 |
| 8 | 2.83 | 7.81 | 77.0 |
| 9 | 2.90 | 8.00 | 80.5 |
| 10 | 2.83 | 8.00 | 90.5 |
| 11 | 2.70 | 7.75 | 82.0 |
| 12 | 3.16 | 8.38 | 128.9 |

TABLE 5

| SAMPLE#3 - MALEIC ANHYDRIDE TERMINATED POLYIMIDE - 400°C POST-BAKE FOR 6 HOURS | | | |
|---|---|---|---|
| | MODULUS (Y, GPA) | YIELD ELONGATION(%) | BREAKWAFER ELONGATION(%) |
| 1 | 3.27 | 7.25 | 79.1 |
| 2 | 3.61 | 7.30 | 68.0 |
| 3 | - | 8.75 | 79.1 |
| 4 | 2.87 | 8.38 | 80.6 |
| 5 | 3.84 | - | 90.3 |
| 6 | 3.13 | 7.25 | 85.1 |
| 7 | - | - | 80.7 |
| 8 | 3.30 | 8.30 | 93.3 |
| 9 | 3.12 | 7.13 | 81.1 |
| 10 | - | 8.00 | 82.0 |
| 11 | 3.07 | 7.63 | - |
| 12 | 3.19 | 7.25 | 86.0 |
| 13 | 3.51 | 7.13 | 78.0 |
| 14 | - | 7.00 | 86.5 |
| 15 | - | 6.93 | 94.9 |

TABLE 6

| CONTROL#3 - PROBIMIDE® 400 - 400°C POST-BAKE FOR 6 HOURS | | | |
|---|---|---|---|
| | MODULUS (Y, GPa) | YIELD ELONGATION(%) | BREAKWAFER ELONGATION(%) |
| 1 | 3.26 | 6.00 | 69.9 |
| 2 | 3.68 | 6.38 | 69.6 |
| 3 | - | 6.50 | 69.5 |
| 4 | 3.34 | 6.88 | 97.3 |
| 5 | - | 5.88 | 62.1 |
| 6 | 3.65 | 6.88 | 79.8 |
| 7 | 3.98 | 6.88 | 92.4 |
| 8 | 3.52 | 7.25 | 70.0 |
| 9 | - | - | - |
| 10 | 3.17 | 6.80 | 83.6 |
| 11 | 3.53 | 6.38 | 91.1 |
| 12 | 3.70 | 6.13 | 87.9 |
| 13 | - | - | - |
| 14 | 3.29 | 7.00 | 90.1 |
| 15 | 3.42 | 5.70 | 77.6 |

**Claims**

1. A maleic anhydride terminated homopolyimide or copolyimide of at least one aromatic tetracarboxylic acid and at least one aromatic diamine which essentially consists of 5 to 99.999 mol% of at least one structural element of the formula I

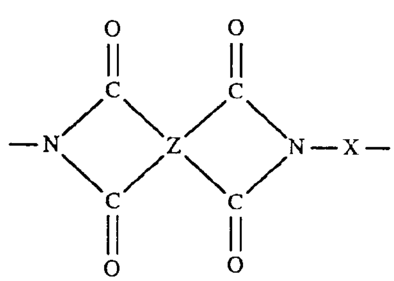

(I)

and 95-0 mol % of at least one structural element of the formula II

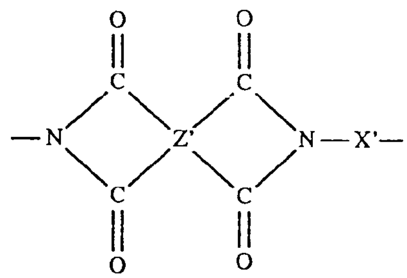

(II)

wherein Z is an unsubstituted tetravalent aromatic radical to which in each case two carbonyl groups are bonded in the ortho- or peri-position, X is the divalent radical of an aromatic diamine, Z′ has the same meaning as Z, or is a different tetravalent organic radical to Z, and X′ is the divalent radical of an organic diamine which differs from X, wherein the aromatic radical of X is substituted in the two ortho-positions relative to at least one N atom by alkyl, cycloalkyl, alkoxy, alkoxyalkyl or aralkyl, or wherein two adjacent C atoms of the aromatic radical are substituted by alkylene and wherein said homopolyimide or copolyimide contains about 0.0001 to about 25 mol % maleic anhydride groups and has a molecular weight of at least 10,000.

2. A maleic anhydride terminated homopolyimide or copolyimide according to claim 1 containing about 0.0001 to about 0.100 mol %, preferably about 0.0001 to 0.0005 mol %, maleic anhydride groups.

3. A maleic anhydride terminated homopolyimide or copolyimide according to claim 1 wherein said aromatic radical X is a divalent, mononuclear or dinuclear phenylene radical.

4. A maleic anhydride terminated homopolyimide or copolyimide according to claim 1 wherein the alkyl or alkoxy substituent of X contains 1 to 20 C atoms, the alkoxyalkyl substituent of X contains 2 to 12 C atoms, the cycloalkyl substituent of X contains 5 or 6 ring carbon atoms, the alkylene substituent of X contains 3 or 4 C atoms and the aralkyl substituent of X is benzyl.

5. A maleic anhydride terminated homopolyimide or copolyimide according to claim 4 wherein the substituent is alkyl with 1 to 4 C atoms, preferably methyl, ethyl or isopropyl.

6. A maleic anhydride terminated homopolyimide or copolyimide according to claim 1 wherein Z and Z′ are

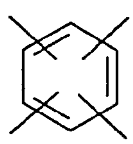 , 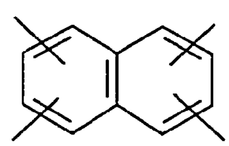 ,

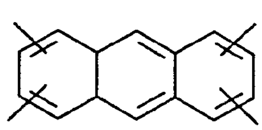 , 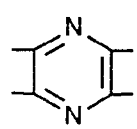 , 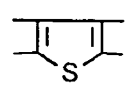 ,

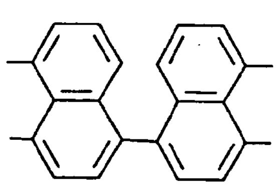 , 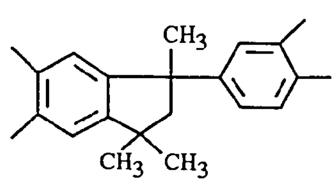 ,

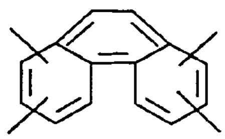

or

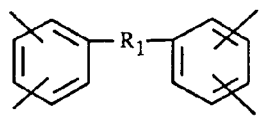

in which $R_1$ is a direct bond or a bridge group of the formula

-O-, -CO-, -S-, $-SO_2-$, 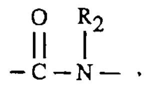 , 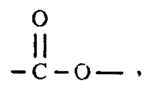 , 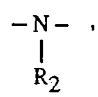 , 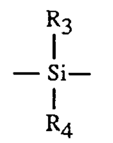 ,

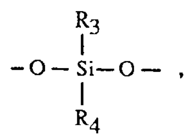 ,

-NH-, 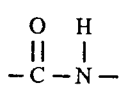 , $-CH_2-$, $-CH_2-CH_2-$, 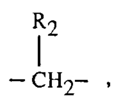 , 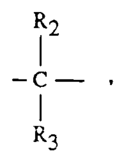 ,

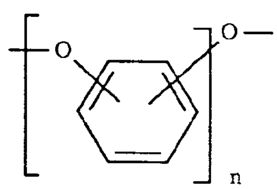

or

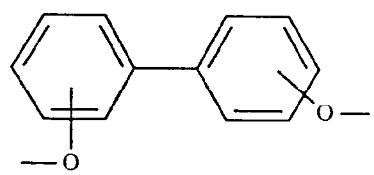

in which $R_2$, $R_3$ and $R_4$ are alkyl with 1 to 6 C atoms, phenyl or benzyl, and $R_3$ and $R_4$ are alkoxy with 1 to 6 C atoms, phenoxy or benzyloxy.

7. A maleic anhydride terminated homopolyimide or copolyimide according to claim 6 wherein Z and Z' are radicals of the formula

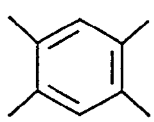 , 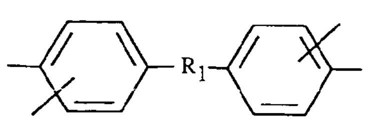

or a mixture thereof wherein $R_1$ is a direct bond, -O-, $-SO_2-$, $-CH_2-$ or -CO-.

8. A maleic anhydride terminated homopolyimide or copolyimide according to claim 7 wherein Z and Z' are radicals of the formula

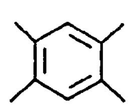 , 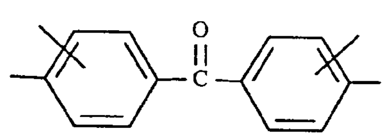

or a mixture thereof.

**9.** A maleic anhydride terminated homopolyimide or copolyimide according to claim 1 wherein said aromatic radical X has the formula III, IIIa, IIIb or a mixture thereof

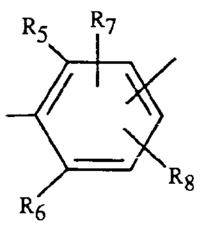 (III) 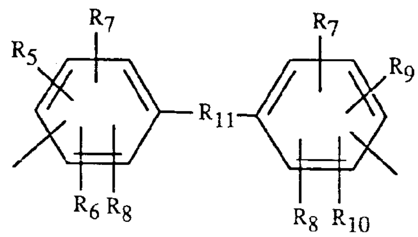 (IIIa)

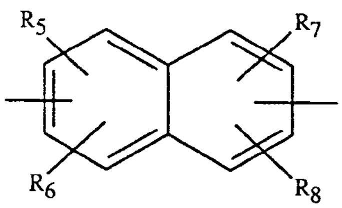 (IIIb)

wherein, in formula III, the free bonds are in the meta- or para-position relative to one another, in formula IIIa the free bonds are preferably in the meta- or para-position relative to the $R_{11}$ group and $R_5$ and $R_6$ are bonded in the two ortho-positions of the free bond, and in formula IIIb the free bonds are in the 2-, 3-, 6- or 7-positions and $R_5$ and $R_6$ are in the two ortho-positions of the free bonds, $R_{11}$ is a direct bond, -O-, -S-, -SS-, -SO-, $-SO_2-$, -CO-, -COO-, -NH-,

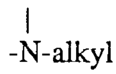

with 1 to 6 C atom in the alkyl,

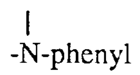 , 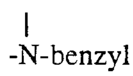 ,

-CONH-, -CON-alkyl- with 1 to 6 C atoms in the alkyl, -CON-phenyl-, -CON-benzyl-,

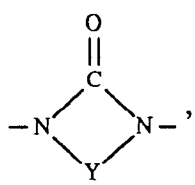 ,

in which Y is

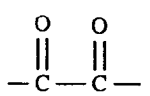 , 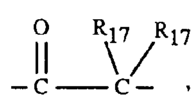 , or 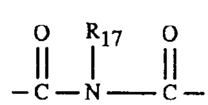

and $R_{17}$ is a hydrogen atom, $C_1$-$C_6$-alkyl or phenyl, linear or branched alkylene with 1 to 3 C atoms, alkylidene which has 2 to 12 C atoms and is unsubstituted or substituted by Cl or F, cycloalkylidene with 5 or 6 ring carbon atoms, phenylene, phenylenedioxy or the group $R_3SiR_4$,

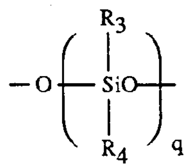 or 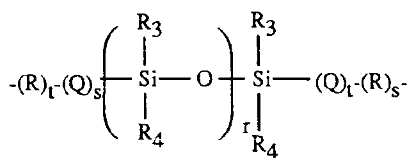 , :

in which $R_3$ and $R_4$ are alkyl or alkoxy with 1 to 6 C atoms, phenyl, benzyl, phenoxy or benzyloxy, r is a number from 1 to 20, t is 0 or 1, s is 0 or 1, R is -O- or -S-, Q is $C_1$-$C_6$-alkylene and q is a number from 1 to 100, $R_5$ and $R_6$ are alkyl, or alkoxy with 1 to 12 C atoms, alkoxyalkyl with 2 to 12 C atoms, cyclopentyl, cyclohexyl or benzyl, or, in the formula III or IIIa, $R_5$ and $R_7$ are bonded in adjacent positions and together are trimethylene or tetramethylene, in which case $R_6$ can also be a hydrogen atom, or $R_7$ and $R_5$ are hydrogen atoms or independently have the meanings of $R_5$ and $R_6$, and $R_9$ and $R_{10}$ are hydrogen atoms or independently have the meanings of $R_5$ and $R_6$, or $R_7$ and $R_9$ in formula IIIa together are trimethylene or tetramethylene.

**10.** A maleic anhydride terminated homopolyimide or copolyimide according to claim 9 wherein $R_5$ and $R_5$ ear alkyl with 1 to 6 C atoms, preferably methyl, ethyl, n-propyl or isopropyl.

**11.** A maleic anhydride terminated homopolyimide or copolyimide according to claim 9 wherein the free bonds in formula IIIa are in the para-position relative to the $R_{11}$ group.

**12.** A maleic anhydride terminated homopolyimide or copolyimide according to claim 9 wherein $R_{11}$ is $-CH_2-$, -O-, -CO- or a direct bond.

**13.** A maleic anhydride terminated homopolyimide or copolyimide according to claim 1 which contains 2 to 4 different structural elements of the formula I and II.

**14.** A maleic anhydride terminated homopolyimide or copolyimide according to claim 13 wherein the structural elements of the formula I differ in the radical X.

**15.** A maleic anhydride terminated homopolyimide or copolyimide according to claim 9 wherein X in formula I is a radical of the formula

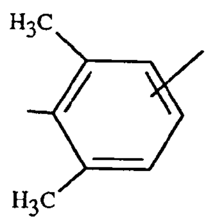 , 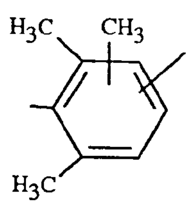 , 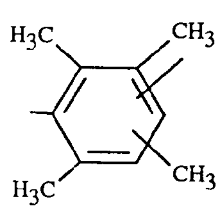 or 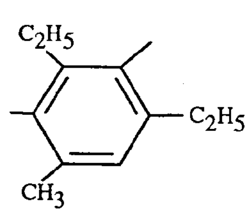

wherein the free bonds are in the meta- or para-position relative to one another, or of the formula

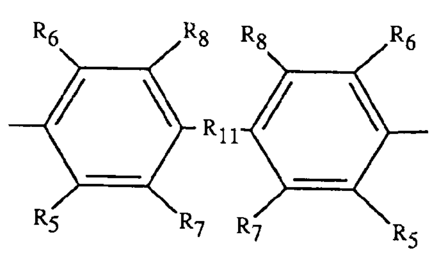

wherein $R_5$ and $R_5$ independently of one another are methyl, ethyl, n-propyl or isopropyl, $R_7$ and $R_5$ are hydrogen atoms or have the meaning of $R_5$, or $R_5$ and $R_7$ together are trimethylene or tetramethylene and $R_6$ and $R_8$ are hydrogen atoms, and $R_{11}$ is a direct bond, $CH_2$, 2,2-propylidene or CO.

**16.** A maleic anhydride terminated homopolyimide or copolyimide according to claim 15 which is a copolyimide

with two or more radicals of the formula

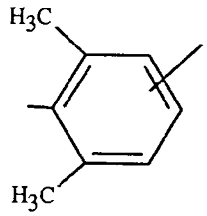 , 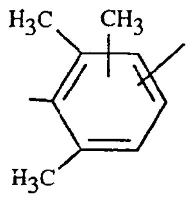 , 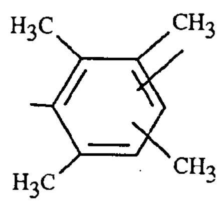 or 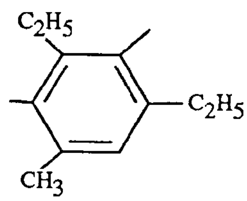

wherein the free bonds are in the meta- or para-position relative to one another, or of the formula

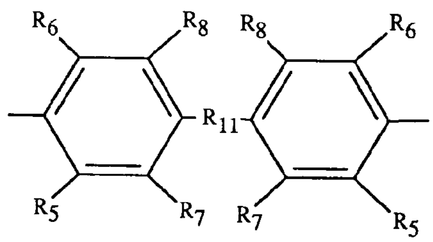

wherein $R_5$ and $R_5$ independently of one another are methyl, ethyl, n-propyl or isopropyl, $R_7$ and $R_5$ are hydrogen atoms or have the meaning of $R_5$, or $R_5$ and $R_7$ together are trimethylene or tetramethylene and $R_6$ and $R_8$ are hydrogen atoms, and $R_{11}$ is a direct bond, $CH_2$, 2,2-propylidene or CO.

**17.** A maleic anhydride terminated homopolyimide or copolyimide according to claim 1 wherein X′ in formula II is alkylene with 2 to 30 C atoms, cycloarylene with 5 to 8 ring carbon atoms, aralkylene with 7 to 30 C atoms, arylene with 6 to 22 C atoms or a polysiloxane radical.

**18.** A maleic anhydride terminated homopolyimide or copolyimide according to claim 17 wherein an arylene radical X′ has the formula

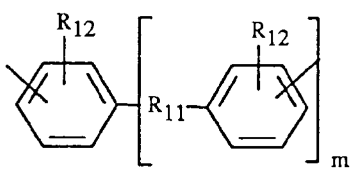

(IV)

in which m is 0 or 1, the free bonds are in the meta-position or the ortho-position relative to the $R_{12}$ group, $R_{11}$ is a direct bond, -O-, -S-, -SS-, -SO-, $-SO_2-$, -CO-, -COO-, -NH-,

|
-N-alkyl

with 1 to 6 C atom in the alkyl,

|
-N-phenyl ,

|
-N-benzyl ,

-CONH-, -CON-alkyl with 1 to 6 C atoms in the alkyl, -CON-phenyl-, -CON-benzyl-,

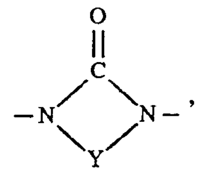

in which Y is

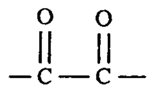 , 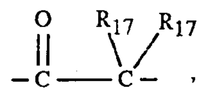 , or 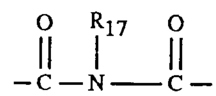

and $R_{12}$ is alkyl or alkyoxy with 1 to 12 C atoms, alkoxyalkyl with 2 to 12 C atoms, cyclopentyl, cyclohexyl or benzyl.

**19.** A maleic anhydride terminated homopolyimide or copolyimide according to claim 18 wherein X′ has the formula IVa, IVb, IVc or a mixture thereof

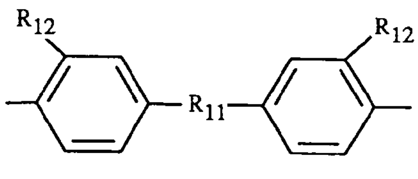 (IVa), 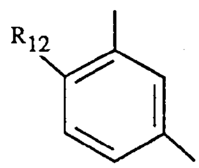 (IVb),

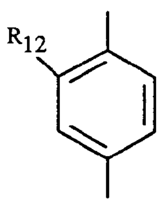 (IVc),

wherein $R_{11}$ is a direct bond, -O-, -CO- or $-CH_2-$ and $R_{12}$ is methyl, ethyl, isopropyl, methoxy, ethoxy or a hydrogen atom.

**20.** A maleic anhydride terminated homopolyimide or copolyimide according to claim 1 which contains 20-100 mol % of structural elements of the formula I and 80-0 mol % structural elements of the formula II.

**21.** A maleic anhydride terminated homopolyimide or copolyimide according to claim 1 which consists of recurring structural elements of the formula

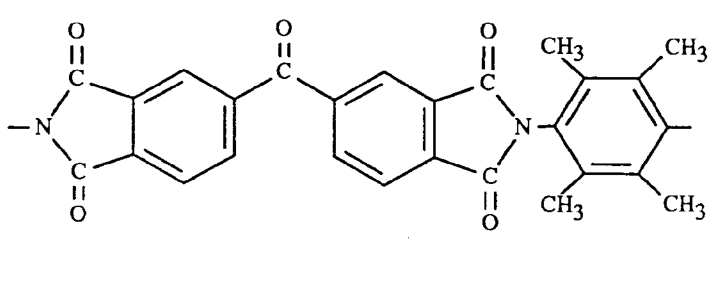 .

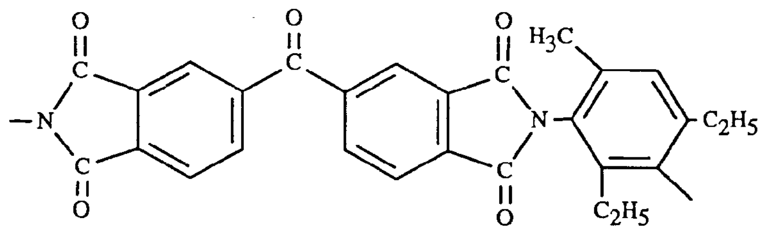

,

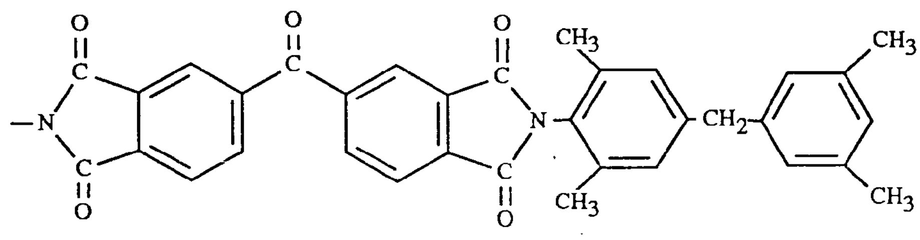

,

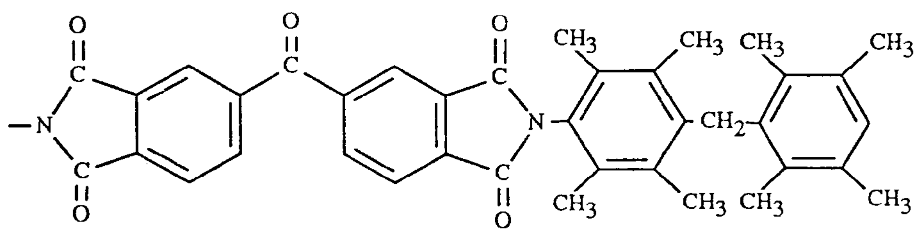

,

or mixtures of such structural elements.

European Patent Office

# EUROPEAN SEARCH REPORT

Application Number

EP 92 81 0659

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| A | PATENT ABSTRACTS OF JAPAN, vol. 012, no. 301 (C-521), 16th August 1988; & JP-A-63 075 034 (KAMEFUCHI) 05-04-1988 | | C 08 G 73/10<br>G 03 F 7/038 |
| A | PATENT ABSTRACTS OF JAPAN, vol. 011, no. 202 (C-432), 30th June 1987; & JP-A-62 027 432 (JAPAN SYNTHETIC RUBBER) 05-02-1987 | | |
| A | EP-A-0 439 915 (TRW INC.) | | |
| A | EP-A-0 395 020 (UBE) | | |
| | | | TECHNICAL FIELDS SEARCHED (Int. Cl.5) |
| | | | C 08 G<br>G 03 F |

The present search report has been drawn up for all claims

| Place of search | Date of completion of the search | Examiner |
|---|---|---|
| THE HAGUE | 07-12-1992 | LEROY ALAIN |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P0401)